# EUROPEAN PATENT APPLICATION

(11) **EP 0 995 765 A1**
(43) Date of publication of application: **26.04.2000**
(21) Application number: 98929836.9
(22) Date of filing: 03.07.1998
(51) Int. Cl.: C08G 59/17, G03F 7/004, G03F 7/027, C08F 299/02

(54) **PROCESS FOR PRODUCING EPOXY ESTER RESINS AND PHOTOSENSITIVE RESIN COMPOSITIONS CONTAINING THEM**

(30) Priority: 04.07.1997 JP 17985797
(71) Applicant: TAKEDA CHEMICAL INDUSTRIES, LTD., Chuo-ku, Osaka 541 (JP)
(72) Inventor: OKUMURA, Hiroya, Takeda Yakuhin, Suita-shi, Osaka 565-0823 (JP); UCHIDA, Toshiaki, Takeda Yakuhin, Ikeda-shi, Osaka 563-0029 (JP); OTSUKI, Kei, Takeda Yakuhin, Fujisawa-shi, Kanagawa 251-0012 (JP); SHIRAKI, Hiroyuki, Kobe-shi, Hyogo 654-0122 (JP)
(74) Representative: Weber, Thomas, Dr.Dipl.-Chem.
(86) International application number: JP9803019
(87) International publication number: WO9901494

(57) **Abstract**

An epoxy ester having excellent storage stability even though epoxy groups, hydroxyl groups and carboxyl groups are present together, and a photosensitive resin composition having excellent storage stability, containing the same are provided.

In a step for forming an epoxy ester by reaction between an epoxy group and a carboxyl group, an organosulfur compound is used as a catalyst.

## Description

### Technical Field

The present invention relates to a process for producing an epoxy ester that can be used extensively in various applications, such as for resist materials for manufacturing printed circuit boards, various image-forming materials including vehicle materials for preparing PDP fluorescent substances, or coating materials.

### Background Art

Epoxy resins are inherently excellent in heat resistance, chemical resistance, adhesiveness, mechanical property, electric characteristics and the like, thus are used in a wide range of materials, including electronic materials. However, even in such epoxy resins having various excellent physical properties described above, there is still a difficulty in handleability.

For example, upon being used for an image-forming material in which field heat resistance, chemical resistance and adhesiveness are required, epoxy resins are suitable as a material. However, substantially developing cannot be conducted with the epoxy resin alone, and therefore it is general to be used with mixing the other resin having developability. In this case, there still remain problems on compatibility between the epoxy resin and the other resin having developability, and handleability, thus there is a limitation on its use.

As a measure for supplementing the above-mentioned defects of the epoxy resin, there has been used a method in which a carboxylic acid-added epoxy ester resin is used, which is obtained by reacting an epoxy compound, a polymeric unsaturated (mono) carboxylic acid and a polybasic acid anhydride. The carboxylic acid-added epoxy ester resin is derived in its basic structure from an epoxy resin. Accordingly, chemical resistance, water resistance, mechanical property etc. thereof are excellent. In addition, the epoxy resin can be cured with either light or heat, and has carboxyl groups therein. Accordingly, developing can be conducted with an alkali aqueous solution, thus the carboxylic acid-added epoxy ester resin is widely used for such uses as image-forming materials including resist materials for printed circuit board.

However, it is hardly to say that the above-mentioned carboxylic acid-added epoxy ester resin has sufficient adhesiveness with a substrate or a filler that is used together with its curing product. As for the use thereof to which high precision is required, such as for the material for electronic products, it is also hardly to say that the carboxylic acid-added epoxy ester resin is sufficiently satisfactory material.

Further, when the carboxylic acid-added epoxy ester resin is used for an image-forming material, such a method is frequently employed in which it is used by mixing with an epoxy resin. However, since a catalyst that has been used upon synthesizing an epoxy ester resin remains, there is such a defect that the storage stability of the resin is lacked.

### Disclosure of the Invention

In view of the above, as one of methods for solving the above-mentioned problems, such a method is conceived that an epoxy ester containing an epoxy group and a carboxyl group in one molecule is produced to use the same.

However, in the conventionally known methods, a catalyst that has been used upon synthesizing the epoxy ester makes the epoxy group and carboxyl group to exist stably in together, with the result that it has been difficult to obtain such a material.

Further, Japanese Patent No. 2593019 discloses a method of improving storage stability by producing a carboxylic acid-added unsaturated epoxy ester using a trivalent phosphorus compound as a catalyst, and thereafter oxidizing this catalyst to inactivate. However, this method has such a defect that gelation of the resin is liable to occur at the stage of oxidizing the catalyst. Further, the method requires an inactivation step of a catalyst, which is unnecessary in the inherent reaction, thus is not sufficiently industrially satisfactory.

Under those circumstances, therefore, an object of the present invention is to provide an epoxy ester-base photosensitive resin composition having excellent storage stability while containing epoxy groups, hydroxyl groups and carboxyl groups in the system. Further, it is an object of the invention to provide a process for producing an epoxy ester and its carboxylic acid adduct, having excellent storage stability.

As a result of extensive investigations to solve the above-mentioned problems, the inventors of the present invention have found that upon an epoxy compound and a carboxylic acid are subjected to react, synthesis of an epoxy ester resin proceeds extremely ideally by using an organosulfur compound. Further, surprisingly they have found that when the organosulfur compound is used as a catalyst, storage stability of the carboxylic acid-added epoxy ester can be markedly improved, which contains one or more epoxy groups and one or more carboxyl groups together in one molecule, and have reached the present invention.

That is, the present invention relates to:
(1) A process for producing an epoxy ester having excellent storage stability, characterized in that an organosulfur compound is used as a catalyst in a step of obtaining the epoxy ester by reacting an epoxy group with a carboxyl group;
(2) The process for producing an epoxy ester as set forth in the above item (1), characterized in that at least one atom is divalent or tetravalent out of sulfur atoms in the organosulfur compound, and metal element and Group VB element are not contained;
(3) A process for producing a carboxylic acid adduct of the epoxy ester as set forth in the above item (1) or (2), which comprises, after production of the epoxy ester, adding a polybasic acid anhydride to the hydroxyl group formed;
(4) A photosensitive resin composition having excellent storage stability, characterized in that it contains the epoxy ester produced by the process as set forth in the above item (1) or (2), an epoxy compound and a carboxyl compound, and contains an organosulfur compound;
(5) A photosensitive resin composition having excellent storage stability, characterized in that it contains a carboxylic acid adduct of the epoxy ester produced by the process as set forth in the above item (3)and an epoxy compound, and contains an organosulfur compound;
(6) A process for producing a self-curable carboxylated epoxy ester resin containing epoxy groups and having excellent storage stability, characterized in that in a step of obtaining an epoxy ester by reacting an epoxy group with a carboxyl group, the carboxyl group is reacted with the epoxy group at a ratio, in equivalent, of less than 1 to the epoxy group to obtain an epoxy ester having unreacted epoxy groups remained therein, and a polybasic acid anhydride is further reacted with the epoxy ester to produce a carboxylic acid adduct of an epoxy group-containing epoxy ester, wherein an organosulfur compound is used as a catalyst in a synthesis reaction of epoxy ester;
(7) A process for producing the epoxy ester, its carboxylic acid adduct or the self-curable carboxylated epoxy ester resin as set forth in any one of the above items (1), (2), (3) and (6), characterized in that the organosulfur compound is thiodiglycol, dithian or thioxane;
(8) A photosensitive resin composition containing the self-curable carboxylated epoxy ester resin obtained by the process as set forth in the above item (6); and
(9) A cured product of the photosensitive resin composition as set forth in any one of the above items (4), (5) and (8).

### Best Mode for carrying out the Invention

In the present invention, the reaction of an epoxy group with a carboxylic acid proceeds extremely equivalently, and also even if a specific operation is not conducted after the completion of synthesis, an epoxy ester having excellent storage stability is obtained. The effect thereof at a room temperature is equivalent to the one in which a catalyst is not substantially contained for accelerating the reaction of an epoxy group and a carboxylic acid. Accordingly, even in the case where one or more carboxyl groups and one or more epoxy groups are present together in one molecule, a carboxylic acid-added epoxy ester containing epoxy group could be obtained which has extremely excellent storage stability. Accordingly, conventionally, even in the use thereof in which a resin having carboxylic acids and an epoxy compound are mixed to use, such as for a resist material, it becomes possible to use as one liquid material. As a result, problems do not arise such as a complicated work upon its use and poor compatibility.

Further, according to the present invention, it is possible to allow one or more epoxy groups to coexist in a carboxylic acid-added unsaturated epoxy ester, and also possible to provide a material having excellent fluidity and good adhesiveness to a substrate in one liquid form while maintaining the inherent radical polymerizability.

In addition, since the photosensitive resin composition of the present invention has excellent storage stability, heat resistance, chemical resistance and the like can be improved by newly adding an epoxy compound. Further, in the present invention, the proportion among hydroxyl group, carboxyl group, epoxy group and unsaturated group can freely be set. For example, by introducing epoxy groups in an amount equivalently larger than carboxyl groups, it is possible to finally form a system in which carboxyl group does not remain in the cured product. Thus, the composition also has such merit that water resistance, electrical characteristics and the like of the cured product can be improved.

Also, since the organosulfur compound remains in the system, there is such an effect that sensitivity to light enhances, and in the case where it is used as a photosensitive resin composition, resulting in the merit to give a material having very excellent photosensitivity.

The present invention is explained in detail below.

As the epoxy compound used in the synthesis of the epoxy ester of the present invention, novolak type epoxy resins represented by cresol novolak type epoxy resin or phenol novolak type epoxy resin, bisphenol type epoxy resins, aliphatic epoxy resins, amine type epoxy resins, copolymerization type epoxy resins, and the like can be used.

Examples of the cresol novolak type epoxy resin include YDCN 701, YDCN 702, YDCN 703 and YDCN 704, products of Tohto Kasei Co. Ltd.; and ESCN 195HH and 220HH, products of Sumitomo Chemical Co. Ltd. Examples of the phenol novolak epoxy resin include YDPN 638, a product of Tohto Kasei Co. Ltd.; Epikote 152 and Epikote 154, products of Yuka Shell Epoxy K.K.; and EPPN 201 and BREN, products of Nippon Kayaku K.K. Examples of the bisphenol type epoxy resin include bisphenol A type epoxy resin represented by YD 128, YD 011, YD 014, YD 017, YD 901 and YD 904, products of Tohto Kasei Co. Ltd., Epikote 828, Epikote 1001, Epikote 1004, Epikote 1007 and Epikote 1009, products of Yuka Shell Epoxy K.K., and ELA 128, ESA 011, ESA 014 and ESA 017, products of Sumitomo Chemical Co. Ltd.; bisphenol F type epoxy resin represented by YDF 170 and YDF 2001, products of Tohto Kasei Co. Ltd., and Epikote 807, a product of Yuka Shell Epoxy K.K.; bisphenol S type epoxy resin represented by EBPS-300, a product of Nippon Kayaku K.K.; and brominated epoxy resins represented by YDB 400, YDB 406 and YDB 412, products of Tohto Kasei Co. Ltd., and Epikote 5050 and Epikote 5051, products of Yuka Shell Epoxy K.K., and ELB 240 and ELB 250, products of Sumitomo Chemical Co. Ltd. Examples of the aliphatic type epoxy resin include hydrogenated bisphenol A type epoxy resin represented by ST-1000 and ST-3000, products of Tohto Kasei Co. Ltd., propylene glycol polyglycidyl ether and pentaerythritol polyglycidyl ether. Example of the amine type epoxy resin includes YH-434, a product of Tohto Kasei Co. Ltd. Example of the copolymerization type epoxy resin includes a copolymer of glycidyl methacrylate and styrene. Those can be used alone or as mixtures of two or more thereof. As the epoxy compound used in the present invention, epoxy compounds having at least two epoxy groups in one molecule are desirable for the development of sufficient heat resistance, chemical resistance and the like.

Examples of the compound containing carboxylic acid include aliphatic monocarboxylic acids such as formic acid, acetic acid, propionic acid, butyric acid, isobutyric acid, lauric acid, myristic acid, palmitic acid and stearic acid; aromatic monocarboxylic acids such as toluic acid and naphthoic acid; monocarboxylic acids having diol compound such as dimethylol acetic acid, dimethylol propionic acid, dimethylol butanoic acid, dimethylol butyric acid, dimethylol valeric acid and dimethylol caproic acid; unsaturated group-containing monocarboxylic acids such as acrylic acid, methacrylic acid, crotonic acid and cinnamic acid; dicarboxylic acids such as maleic acid, succinic acid, phthalic acid, tetrahydrophthalic acid and hexahydrophthalic acid; and polycarboxylic acids such as trimellitic acid and pyromellitic acid. Monocarboxylic acids are desirable as the compound containing carboxylic acid used in the present invention.

In the epoxy esterification reaction of this epoxy compound and carboxylic acid, the equivalent ratio of carboxyl group in carboxylic acid/epoxy group in epoxy compound can be any optional ratio depending on the required physical properties or the addition amount of the polybasic acid anhydride.

The catalyst used in synthesizing the epoxy ester resin is an organosulfur compound. It has not been known that the organosulfur compound has the effect as a catalyst in the conventional epoxy esterification reaction, as described in "Vinyl Ester Resin", edited by Vinyl Ester Resin Kenkyukai, page 16, published by Kagaku Kogyo Nipposha. The organosulfur compound used as a catalyst can use any compound so long as it contains sulfur atom. However, considering the stability of the resin after production, compounds not containing metal elements and Group VB elements are desirable.

Suitable examples of the organosulfur compound used as a catalyst include sulfides or disulfides, such as diallyl sulfide, diallyl disulfide, thiodiglycol, 1,2-bis(2-hydroxyethylthio)ethane, 1,4-bis(2-hydroxyethylthio)butane, diphenyl disulfide, dibenzyl disulfide, ditert-butyl disulfide, 3,3'-dithiodipropionic acid, 2,2'-dithiodiethanol, ethyl methylthiopropionate, thiodipropionic acid, dioctyl thiodipropionate, and dimethyl thiodipropionate; cyclic organosulfur compounds such as 1,4-dithian, 1,3-dithian, thiophene, thiophenone, 1,4-thioxane, thionaphthene, thioantholene, γ-thiobutyrolactone, thiotetronic acid, and thioxanthene-9-one; and organosulfur type solvents such as dimethyl sulfoxide and tetramethylene sulfone. Of those, the compounds wherein sulfur is divalent or tetravalent are preferable from the point of activity of catalyst. Particularly preferable compounds are thiodiglycol, dithian and thioxane. Those organosulfur compounds can be added in the proportion of 0.001-10 parts by weight per 100 parts by weight of the epoxy ester resin.

If other catalysts, for example, quaternary ammonium salt or tertiary amine that is generally used in the synthesis of epoxy ester, are used, unreacted epoxy group and carboxylic acid or acid anhydride are reacted in the reaction of the epoxy ester resin and the polybasic acid anhydride, and gelation occurs. Thus, the objective resin cannot be synthesized, or even if synthesized, the resin lacks in storage stability.

The epoxy ester reaction can be conducted under conventional reaction conditions using the above-mentioned organosulfur compound. The reaction is conducted under the reaction temperature condition of 50-160°C, preferably 80-140°C, until completion of the reaction of carboxyl group or epoxy group. In this reaction, in the case of using the unsaturated group-containing carboxylic acid as a compound containing carboxylic acid, it is desirable to blow air or use a polymerization inhibitor for the purpose of preventing gelation due to polymerization of unsaturated double bonds during the reaction. Examples of the polymerization inhibitor include hydroquinone, p-toluquinone, p-methoxyphenol, phenothiazine, triphenyl antimony and copper chloride. The polymerization inhibitor can be added in the proportion of 0.001-2 parts by weight per 100 parts by weight of the epoxy ester resin.

Further, in order to increase stirring efficiency at the time of reaction, it is possible to previously add a diluent at the time of reaction. Any diluent can be used without particular limitation so long as it is inert to epoxy group and carboxyl group, in the conventional organic diluents. Examples of the diluent include ethylene glycol monoalkyl ether acetates such as ethyl acetate, isopropyl acetate, cellosolve acetate, and butyl cellosolve acetate; diethylene glycol monoalkyl ether acetates such as diethylene glycol monomethyl ether acetate, carbitol acetate, and butyl carbitol acetate; acetic acid esters such as propylene glycol monoalkyl ether acetates, and dipropylene glycol monoalkyl ether acetates; ethylene glycol dialkyl ethers; diethylene glycol dialkyl ethers such as methyl carbitol, ethyl carbitol and butyl carbitol; triethylene glycol dialkyl ethers; ethers such as propylene glycol dialkyl ethers, dipropylene glycol dialkyl ethers, 1,4-dioxane and tetrahydrofuran; ketones such as acetone, methyl ethyl ketone, methyl isobutyl ketone, ethyl methyl ketone, cyclohexanone and butyrolactone; hydrocarbons such as benzene, toluene, xylene, tetramethyl benzerre, tetraline, octane and decane; petroleum type solvents such as petroleum ether, petroleun naphtha, hydrogenated petroleum naphtha, and solvent naphtha; dimethyl formamide; and n-methyl pyrrolidone.

In addition to the above diluents, the following compounds can also be used together as the diluent: methyl (meth)acrylate, ethyl (meth)acrylate, n-butyl acrylate, trimethylol propane tri(meth)acrylate, pentaerythritol tetra(meth)acrylate, dipentaerythritol hexaacrylate, pentaerythritol diacrylate monostearate (Aronix M-233, a product of Toagosei Co., Ltd.), aliphatic acid-modified dipentaerythritol polyacrylate (Aronix M-430, a product of Toagosei Co., Ltd.), polyester acrylate, and reactive compound containing unsaturated group, represented by, for example, a reaction product of a dibasic acid anhydride and an alcohol having at least one unsaturated group in one molecule.

Further, in order to improve the stability of the system, there is a method that those catalysts are oxidized at an optional stage after completion of the epoxy ester synthesis. Examples of the oxidizing agent for this oxidation reaction include peroxides such as hydrogen peroxide, sodium peroxide, barium peroxide, and organic peroxides; permanganates such as sodium permanganate and potassium permanganate; chromates such as sodium chromate and potassium chromate; nitric acids such as nitric acid and potassium nitrate; nitrogen oxides such as dinitrogen oxide and dinitrogen trioxide; perchlorates such as sodium perchlorate and potassium perchlorate; metal salts such as ferric chloride and copper sulfate; halogens such as fluorine, chlorine, and iodine; and oxygens such as air, oxygen and ozone. Of those, a method of using hydrogen peroxide is simple and preferable.

The amount of those oxidizing agents used is 1-5 moles, preferably 1-3 moles, per mole of the sulfur compound remained in the system. If the amount is less than 1 mole, the oxidation reaction is not sufficient, and the effect is not obtained sufficiently. Further, if the amount exceeds 5 moles, resulting in using unnecessarily a large amount of raw materials, which is not economical.

The oxidation reaction of the sulfur compound in the present invention can be conducted such that the oxidizing agent is added during the period of from completion of the epoxy ester reaction to completion of the carboxylic acid-modified epoxy esterification reaction, and the reaction is conducted at in a temperature range of 20-160°C, preferably 20-130°C. If the temperature is lower than 20°C, the reaction time is too long, and further if the temperature is higher than 160°C, there is a possibility that gelation occurs during oxidation operation, which is not preferable.

The carboxylic acid-added epoxy ester resin can-be produced by reacting the polybasic acid anhydride with the epoxy ester resin obtained by the reaction between the epoxy compound and carboxylic acid. Examples of the polybasic acid anhydride used in the synthesis of the carboxylic acid-added epoxy ester resin include dibasic acid anhydrides such as maleic anhydride, succinic anhydride, phthalic anhydride, tetrahydrophthalic anhydride, and hexahydrophthalic anhydride; and polybasic acid anhydrides such as trimellitic acid anhydride, pyromellitic acid anhydride, benzophenonetetracarboxylic anhydride, 5-(tetrahydro-2,5-dioxo-3-furanyl)-3-methyl-3-cyclohexene-1,2-dicarboxylic anhydride. Those can be used alone or as mixtures of two or more thereof.

The equivalent ratio of those acid anhydrides and hydroxyl groups in the epoxy ester is 0.05-1.0, more preferably 0.1-1.0. If the equivalent ratio is less than 0.05, for example, solubility for alkali that is required as image-forming materials is not sufficient. Further, if it exceeds 1.0, polybasic acid anhydride remains, resulting in markedly decreasing storage stability of the carboxylic acid-added epoxy ester resin. The reaction of the epoxy ester resin and the polybasic acid anhydride can be conducted under conventional conditions. The reaction can be conducted in a temperature range of 50-160°C, preferably 80-140°C. Further, similarly to the case of the abovedescribed reaction of the epoxy resin and carboxylic acid, additives such as a diluent can be added to the reaction system. The kind and amount of the diluent are the same as used in synthesizing the epoxy ester resin.

The carboxyl acid-modified epoxy ester resin obtained by the process as described above has excellent storage stability.

Further, according to the present invention, it is also possible to obtain the carboxylic acid-added epoxy ester containing one or more epoxy groups having excellent storage stability. That is, upon obtaining the epoxy ester resin by reacting an epoxy group with a carboxylic acid, the objective product is obtained by adding the polybasic acid anhydride to the epoxy ester resin in which the equivalent ratio of carboxylic acid to epoxy group is less than 1 and unreacted epoxy groups remained in the system. In this case, one or more epoxy groups and one or more carboxyl groups are present together in one molecule, but according to the present invention, resins that have not conventionally be obtained can be obtained.

Next, a photosensitive resin composition using the epoxy ester of the present invention is explained. There is no particular limitation in the use amount of the carboxylic acid-added epoxy ester resin containing one or more epoxy groups and/or one or more carboxyl groups in one molecule contained in this composition.

Polymerizable, reactive diluent or solvent can-be added to the photosensitive resin composition of the present invention as a diluent at the time of or after synthesis. Examples of the polymerizable, reactive diluent which can be used include vinyl ethers, acrylates, acrylamides, epoxy compounds, oxetane compounds, and carbonate compounds.

Examples of the vinyl ethers include aliphatic vinyl ethers such as triethylene glycol divinyl ether, dodecylvinyl ether, cyclohexane dimethanol divinyl ether, or hydroxybutylvinyl ether; aromatic vinyl ethers obtained by the reaction of, for example, chloroethylvinyl ether with various phenols; urethane type vinyl ethers obtained by the reaction of, for example, hydroxyvinyl ether with various isocyanate compounds; ester type vinyl ethers obtained by the reaction of, for example, hydroxyvinyl ether with polycarboxylic acid derivatives; and various styrene derivatives.

Examples of the acrylates include methyl (meth)acrylate, ethyl (meth)acrylate, n-butyl (meth)acrylate, isobutyl (meth)acrylate, 2-ethylhexyl (meth)acrylate, isodecyl (meth)acrylate, n-lauryl (meth)acrylate, tridecyl (meth)acrylate, n-stearyl (meth)acrylate, methoxypolyethylene glycol (meth)acrylate, cyclohexyl (meth)acrylate, tetrahydrofurfuryl (meth)acrylate, isoboronyl (meth)acrylate, benzyl (meth)acrylate, 2-hydroxyethyl (meth)acrylate, 2-hydroxypropyl (meth)acrylate, 2-hydroxybutyl (meth)acrylate, dimethylaminoethyl (meth)acrylate, diethylaminoethyl (meth)acrylate, ethylene glycol di(meth)acrylate, diethylene glycol di(meth)acrylate, 1,4-butanediol di(meth)acrylate, 1,6-hexanediol di(meth)acrylate, trimethylol propane tri(meth)acrylate, glycerine di(meth)acrylate, pentaerythritol tri(meth)acrylate, pentaerythritol tetra(meth)acrylate, dipentaerythritol hexa(meth)acrylate, pentaerythritol diacrylate monostearate (Aronix M-233, a product of Toagosei Co., Ltd.), fatty acid-modified dipentaerithritol polyacrylate (Aronix M-430, a product of Toagosei Co., Ltd.) polyester acrylates and reaction products of dibasic acid anhydride and alcohol having at least one unsaturated group in one molecule.

Examples of the epoxy compounds include compound similar to the above-described epoxy resins, and oxirane compounds such as ethylene oxide or propylene oxide. Examples of the oxetane compounds include 3-methyl-3-hydroxymethyl oxetane, 1,4-bis((3-ethyl-3-oxetenylmethoxy)methylbenzene, 3-ethyl-3-hydroxymethyl oxetene, and oxetane oligomers. Examples of the carbonate compounds include ethylene carbonate and propylene carbonate.

As the examples of the solvent, in addition to the above-described solvents, alcohols may be used. Examples thereof include methanol, ethanol, propanol, cyclohexanol, ethylene glycol, propylene glycol, ethylene glycol monoalkyl ethers such as methyl cellosolve, ethyl cellosolve or butyl cellosolve, diethylene glycol monoalkyl ethers such as diethylene glycol monomethyl ether or diethylene glycol monoethyl ether, triethylene glycol monoalkyl ethers such as triethylene glycol monomethyl ether, propylene glycol monoalkyl ethers such as propylene glycol monomethyl ether, and dipropylene glycol monoalkyl ethers such as dipropylene glycol monoalkyl ether. Those diluents may be used alone or as mixtures of two or more thereof, and there is no particular limitation in the amount of the diluent contained in the composition of the present invention.

Radical curing agents, cation curing agents and the like can be used as the polymerization initiator. Examples of the cation curing agent include triphenyl hexafluoroantimonate, triphenylsulfonium hexafluorophosphate, 4,4'-bis[bis(2-hydroxyethoxyphenyl)sulfonio]phenylsulfide bishexafluoro-phosphate, diphenyliodonium hexafluoroantimonate, and diphenyl-4-thiophenoxyphenylsulfonium hexafluorophosphate.

Photoradical polymerization initiators which can be used are acetophenone type, benzoin type, benzophenone type, thioxanthone type, and phosphorus type. Examples of the acetophenone type include diethoxyacetophenone, 2-hydroxy-2-methyl-1-phenylpropan-1-one, benzyldimethyl ketal (Irgacure 651, a product of Ciba Geigy), 2-methyl-2-morphorino(4-thiomethylphenyl)propan-1-one (Irgacure 907, a product of Ciba Geigy), and 2-benzyl-2-dimethylamino-1-(4-morphorinophenyl)-butanone (Irgacure 369, a product of Ciba Geigy). Examples of the benzoin type include benzoin, benzoin methyl ether, and benzoin ethyl ether. Examples of the benzophenone type include benzophenone, hydroxybenzophenone, 4-phenylbenzophenone and 3,3',4,4'-tetra(t-butyl peroxycarbonyl)benzophenone (BTTB, a product of Nippon Oils and Fats K.K.). Examples of the thioxanthone type include 2-isopropylthioxanthone, 2,4-dimethylthioxanthone and 2,4-diethyl thioxanthone (Kayacure DETX, a product of Nippon Kayaku K.K.). Examples of the phosphorus type include acylphosphine oxide (Rucitin TPO, a product of BASF).

Those polymerization initiators are used alone or as mixture of two or more thereof. The amount of the polymerization initiator contained in the composition of the present invention is preferably 0.01-20% by weight, particularly preferably 1-10% by weight, in the polymer composition. If the addition amount is less than 0.01, sufficient curing is difficult to obtain, and physical properties lower. Further, if it exceeds 20% by weight, cost for the materials become expensive, which is not preferable.

It is possible for the photosensitive composition of the invention to use together various light- or heat-curable resins represented by epoxy resins, melamine resins, isocyanate resins and oxazoline resins.

Further, polymerization inhibitors, fillers, defoaming agents, colorants, leveling agents and the like can be added to the polymeric composition of the present invention. Examples of the polymerization inhibitor include hydroquinone, p-toluquinone, phenothiazine and diketone.

Examples of the filler include talc, barium sulfate and silica. Example of the defoaming agent includes silicone oil. Examples of the colorants include phthalocyanine blue, leuco dyes, carbon black and titanium oxide.

The polymeric composition of the present invention is obtained by uniformly stirring and kneading blending components with a disper, a roll mill, a resolver or the like.

In case of using the polymeric composition of the present invention as a solder resist resin composition, a cured product can be obtained by curing with, for example, the following method. That is, the polymeric composition of the present invention is applied onto a printed wiring board with a method such as screen printing method, spraying method, curtain coating method, roll coating method, dip coating method, doctor knife method or electrostatic coating method to a coating thickness of 10-200 µm, and the coating film is dried at 60-110°C to remove an organic solvent. After drying, a negative film is directly contacted with the coating film, ultraviolet ray is irradiated (light exposure) using a high pressure mercury lamp, a metal halide lamp or the like, and unexposed portion is washed out (development) with about a 1-2% diluted alkali aqueous solution. Thereafter, in order to improve various physical properties, irradiation with ultraviolet ray and/or heating (for example, 100-200°C, 30-60 minutes) are conducted to perform sufficient curing, thereby obtaining a cured film.

### Examples

The present invention is explained in further detail by the examples, but the invention is not limited thereto. All parts in the Synthesis Examples are parts by weight.

### Synthesis Example 1

203 Parts (1 equivalent) of cresol novolak type epoxy resin (YDCN 702P, a product of Tohto Kasei Co. Ltd.., epoxy equivalent: 203), 57.6 parts (0.8 equivalent) of acrylic acid, 174 parts of carbitol acetate, and 0.34 part (0.0031 mol) of hydroquinone as a polymerization inhibitor were charged in a 1 liter four-necked Kolben equipped with a stirrer.

When 3.4 parts (0.028 mol) of thiodiglycol were then charged and reaction was conducted at 120°C for 3 hours, an acid value of the reaction system was 0.

Subsequently, 77.5 parts (0.51 equivalent) of tetra-hydrophthalic anhydride were charged, and reaction was conducted for 3 hours. It was confirmed by an infrared absorption spectrum that acid anhydride was completely reacted, and an epoxy group-containing carboxylic acid-added epoxy ester (1) having an acid value of nonvolatile content of 84.6 mgKOH/g and a nonvotatile content of 66% was obtained.

### Synthesis Example 2

An epoxy group-containing carboxylic acid-added epoxy ester (2) was obtained in the same manner as in Synthesis Example 1 except that 3.4 parts (0.028 mol) of thiodiglycol were changed to 5.0 parts (0.042 mol) of thioxane.

### Synthesis Example 3

An epoxy group-containing carboxylic acid-added epoxy ester (3) was obtained in the same manner as in Synthesis Example 1 except that 3.4 parts (0.028 mol) of thiodiglycol were changed to 4.0 parts (0.051 mol) of dimethyl sulfoxide.

### Synthesis Example 4

An epoxy group-containing carboxylic acid-added epoxy ester (4) was obtained in the same manner as in Synthesis Example 1 except that 3.4 parts (0.028 mol) of thiodiglycol were changed to 2.4 parts (0.020 mol) of 1,4-dithian.

### Comparative Example 1

Synthesis was conducted in the same manner as in Synthesis Example 1 except that 3.4 parts (0.028 mol) of thiodiglycol were changed to 3.0 parts (0.0115 mol) of triphenyl phosphine. As a result, gelation occurred before the reaction of tetrahydrophthalic anhydride.

### Comparative Example 2

An epoxy group-containing carboxylic acid-added epoxy ester (5) was obtained in the same manner as in Synthesis Example 1 except that 3.4 parts (0.028 mol) of thiodiglycol were changed to 2.0 parts (0.0148 mol) of dimethylbenzyl amine.

The carboxylic acid-modified epoxy ester resins obtained in Synthesis Examples 1-3 and Comparative Examples 1-2 were examined on viscosity change at 40°C after 1 month, and storage stability was examined. The results are shown in Table 1.

**Table 1**

| Resin | Viscosity change at 40°C after 1 month(measurement at 25°C) |
|---|---|
| Synthesis Example 1 | 1.8 times |
| Synthesis Example 2 | 1.7 times |
| Synthesis Example 3 | 1.9 times |
| Synthesis Example 4 | 1.6 times |
| Comparative Example 1 | ---- |
| Comparative Example 2 | Gelled after 3 days |

### Example

Resist ink resin compositions were blended according to the following formulation.

Preparation of resist ink resin composition

| | |
|---|---|
| Carboxylic acid-added epoxy ester obtained in each of Synthesis Examples 1-3 or carboxylic acid-added epoxy ester obtained in Comparative Example 2: | |
| | 154 parts by weight |
| Carbitol acetate: | 18 parts by weight |
| Ipsol 150 (made by Idemitsu Petrochemical Co., Ltd.): | 5 parts by weight |
| Aronix M-233 (made by Toagosei Co., Ltd.): | 22 parts by weight |
| Kayacure DETX (made by Toagosei Co., Ltd.): | 0.1 parts by weight |
| Irgacure 907 (made by Ciba Geigy): | 15 parts by weight |
| YD 901 (made by Toto Kayaku K.K.): | 5 parts by weight |
| EPPN 201 (made by Nippon Kasei K.K.): | 10 parts by weight |
| TEPIC (triglycidylether isocyanurate) (mady by Nissan Kagaku K.K.): | 20 parts by weight |
| Dicyandiamide (curing catalyst): | 1.0 parts by weight |
| Imusil A-108 (made by Tatsumori K.K.) (silica filler): | 60 parts by weight |
| Aerosil 200 (made by Nippon Aerosil K.K.): | 8 parts by weight |
| Barium sulfate: | 30 parts by weight |
| Phthalocyanine Green (colorant): | 1.4 parts by weight |
| KF-69 (made by Shin-Etsu Silicone K.K.)(defoaming agent): | 2.0 parts by weight |
| Microace K-1 (made by Shiraishi Calcium K.K.) (talc filler): | 110 parts by weight |
| Total | 461.5 parts by weight |

Resist ink compositions were blended according to the above blending formilation, and each of the resulting compositions was applied onto the entire surface of a printing substrate having a thickness of 1.6 mm to a coating thickness of 25 µm by screen printing using a 180 mesh polyester screen plate. The coating film was dried at 85°C for 40 minutes to remove a solvent. Ultraviolet ray was irradiated through a negative mask with an exposure amount of 350 mJ/cm², and development was conducted with an 1% sodium carbonate aqueous solution at 30°C for 40 seconds under a spray pressure of 2.0 kg/cm² to dissolve an unexposed portion. At this time, the following evaluation was conducted on the developability of the unexposed portion. Those results are shown in Table 2.

### (Developability)

Each resist ink composition was applied onto the entire surface of a printing plate to a coating thickness of 25 µm, and dried at 85°C. The relationship between lapse of drying time and developability of resist coating was examined. That is, the resist coating was light exposed through a pattern every specific drying time, and developed with sodium carbonate aqueous solution as described above. In this manner, the period of time until an unexposed portion cannot be dissolved and development becomes impossible was measured. As this time is long, there is a sufficient time before exposure after resist coating. As a result, the process management becomes easy, workability is improved and also reliability is improved.

**Table 2**

| Resin | Developable time (min) |
|---|---|
| Synthesis Example 1 | 90 |
| Synthesis Example 2 | 90 |
| Synthesis Example 3 | 90 |
| Synthesis Example 4 | 90 |
| Comparative Example 1 | -- |
| Comparative Example 2 | 70 |

After development, heat curing was conducted in a hot air drier at 160°C for 40 minutes to obtain a cured film. Each cured film was subjected to an adhesiveness test by a cross-hatch adhesiveness test and a solder heat resistance test by a solder float test of 260°C x 10 seconds. It was seen that there is no problem in both tests, and the cured film has sufficient characteristics.

Further, when each resin composition solution was stored at 25°C, the resin composition prepared by Comparative Example 2 gelled after one day, and could not be used, but other resin compositions did not gel even after two weeks, and their cured products showed physical properties equivalent to the initial physical properties thereof.

### Industrial Applicability

As described above, the epoxy ester obtained by using an organosulfur compound as a catalyst according to the present invention has the characteristics that it has excellent storage stability even though epoxy groups, hydroxyl groups and carboxyl groups in curing amounts are present together in a system, and can easily be cured by light or heat.

Further, according to the present invention, synthesis of the epoxy group-containing carboxylic acid-added epoxy ester is easy, and an alkali-soluble resist material which has not conventionally be obtained can be provided. Since its cured product has sufficient adhesiveness, heat resistance, and the like, it is suitable as image-forming materials such as solder resist materials, or vehicle materials for preparing PDP fluorescent substance.

## Claims

1. A process for producing an epoxy ester having excellent storage stability, characterized in that an organosulfur compound is used as a catalyst in a step of obtaining the epoxy ester by reacting an epoxy group with a carboxyl group.

2. The process for producing an epoxy ester as claimed in claim 1, characterized in that at least one atom is divalent or tetravalent out of sulfur atoms in the organosulfur compound, and metal element and Group VB element are not contained.

3. A process for producing a carboxylic acid adduct of the epoxy ester as set forth in claim 1 or 2, which comprises, after production of the epoxy ester, adding a polybasic acid anhydride to the hydroxyl group formed.

4. A photosensitive resin composition having excellent storage stability, characterized in that it contains the epoxy ester produced by the process as claimed in claim 1 or 2, an epoxy compound and a carboxyl compound, and contains an organosulfur compound.

5. A photosensitive resin composition having excellent storage stability, characterized in that it contains a carboxylic acid adduct of the epoxy ester produced by the process as set forth in claim 3 and an epoxy compound, and contains an organosulfur compound.

6. A process for producing a self-curable carboxylated epoxy ester resin containing epoxy groups and having excellent storage stability, characterized in that in a step of obtaining an epoxy ester by reacting an epoxy group with a carboxyl group, the carboxyl group is reacted with the epoxy group at a ratio, in equivalent, of less than 1 to the epoxy group to obtain an epoxy ester having unreacted epoxy groups remained therein, and a polybasic acid anhydride is further reacted with the epoxy ester to produce a carboxylic acid adduct of an epoxy group-containing epoxy ester, wherein an organosulfur compound is used as a catalyst in the synthesis reaction of the epoxy ester.

7. A process for producing the epoxy ester, the carboxylic acid adduct or the self-curable carboxylated epoxy ester resin as set forth in any of claims 1, 2, 3 and 6, characterized in that the organosulfur compound is thiodiglycol, dithian or thioxane.

8. A photosensitive resin composition containing the self-curable carboxylated epoxy ester resin obtained by the process as set forth in claim 6.

9. A cured product of the photosensitive resin composition as set forth in any of claim 4, 5 and 8.
